# NEUE EUROPÄISCHE PATENTSCHRIFT

(11) **EP 3 045 088 B2**
(45) Veröffentlichungstag und Bekanntmachung des Hinweises auf die Entscheidung über den Einspruch: **28.06.2023**
(45) Hinweis auf die Patenterteilung: 05.09.2018
(21) Anmeldenummer: 16151273.6
(22) Anmeldetag: 14.01.2016
(51) Int. Cl.: A47F 11/10, A47F 5/08

(54) **PRÄSENTATIONSEINRICHTUNG, INSBESONDERE FÜR WAREN**
DISPLAY STAND, IN PARTICULAR FOR GOODS
DISPOSITIF DE PRESENTATION, EN PARTICULIER DE MARCHANDISES

(30) Priorität: 16.01.2015 DE 102015000272
(43) Veröffentlichungstag der Anmeldung: 20.07.2016
(60) Teilanmeldung: 18180886.6
(73) Patentinhaber: GESA Form + Funktion Displaybau GmbH, 63303 Dreieich-Offenthal (DE)
(72) Erfinder: Rau, Otmar, 63303 Dreieich-Götzenhain (DE)
(74) Vertreter: 2K Patentanwälte Blasberg Kewitz & Reichel

(56) Entgegenhaltungen:
- EP-A2- 2 220 965
- US-A1- 2007 221 595
- US-A1- 2013 068 171
- US-A1- 2014 104 826

## Beschreibung

### Gebiet der Erfindung

Die Erfindung betrifft allgemein die Präsentation von Waren, wie beispielsweise von Kosmetikartikeln oder von Text- und/oder Graphikinformation zu Werbezwecken im Zusammenhang mit beliebigen Waren/Dienstleistungen und betrifft insbesondere eine Präsentationseinrichtung mit einer Mehrzahl von Präsentationsmodulen, die in einfacher Weise sowohl bei Umrüstungen als auch bei Neueinbauten in Verkaufslokalen variabel konfigurierbar sein soll.

### Stand der Technik

Präsentationseinrichtungen der vorgenannten Art für Waren werden als Bestandteil von Verkaufstheken, auch Display genannt, in Verkaufslokalen wie beispielsweise Supermärkten oder Drogeriemärkten aufgestellt und bieten dem Kunden die Möglichkeit, ein bestimmtes Produkt, z. B. ein Kosmetikprodukt, zu präsentieren. Das fertige System als Bestandteil eines Displays steht beispielsweise in einer Drogerie, Kaufhaus, Parfümerie, etc. und präsentiert Ware (z.B. Kosmetikartikel) zum Abverkauf an den Endverbraucher. Das finale Produkt gibt es je nach Kundenanforderung in unterschiedlichen Optiken.

Anbieter von Kosmetikprodukten haben oftmals ein eigenes Display in Verkaufsräumen, in dem sie ihre Produkte in einer einheitlichen Form darstellen. Als Bestandteil der Displays werden Präsentationssysteme mit Modulen benötigt, um zum einen die Waren aufzunehmen und um zum anderen diese zu präsentieren.

Bisher werden Unterbauten für Präsentationssysteme individuell und meist nicht flexibel auf Kundenbedürfnisse, aus Metall, Holz und Kunststoff hergestellt. Umbauten bestehender Konstruktionen waren meist nicht möglich, oder sehr umständlich.

Gerade für die Warenpräsentation sind formschön gestaltete Module gesucht, die einerseits kostengünstig und flexibel konfigurierbar hergestellt werden können und andererseits ausreichend robust sind.

WO 2006067396 A1 und DE202014103767 U1 offenbaren eine Präsentationseinrichtung mit einer Mehrzahl von übereinander angeordneten Regalböden. Zur werbewirksameren Präsentation von Waren sind die Regalböden mit Beleuchtungseinrichtungen versehen. Die elektrische Versorgung dieser Beleuchtungseinrichtungen erfolgt über die Befestigung der Regalböden an einem Wandpaneel oder einer Haltesäule.

DE 202012009052 U1 offenbart eine Präsentationseinrichtung mit einer Mehrzahl von Paneelen, an deren Vorderseite zu präsentierende Waren ausgestellt sind. Die Paneele sind mit Hilfe eines Befestigungsrahmens oder Befestigungselementen an einem weiteren Paneel oder einer Wand lösbar befestigt.
Zur geordneten Präsentation von Waren werden zumeist variable Unterteilungen in Gestalt von sich kreuzenden Leisten verwendet, die auf der Oberseite von Regalböden oder dergleichen angeordnet sind, wie beispielsweise in EP 0773727 B1 offenbart.

Zur wirkungsvolleren und attraktiveren Präsentation von Waren haben sich, gerade im Bereich von Kosmetikartikeln, Präsentationseinrichtungen bewährt, die mit Ablageplatten aus einem transparenten Material, wie beispielsweise transparentem Kunststoff, versehen sind, die eine Hintergrund-Beleuchtungsfunktion zur Hintergrundbeleuchtung für die zu präsentierenden Waren ermöglichen. Die Ablageplatten wirken dabei als Lichtleiter, aus dem das Licht zur Hintergrundbeleuchtung der Ware in geeigneter Weise ausgekoppelt wird. Derartige Präsentationseinrichtungen sind beispielsweise in dem deutschen Gebrauchsmuster 202013104137 der Anmelderin offenbart.

Die Druckschriften EP 2 220 965 A2, US 2014/104826 A1, US 2007/221595 A1, US 2013/068171 A1 offenbaren unterschiedliche Regalsysteme mit Einsätzen.

### Zusammenfassung der Erfindung

Aufgabe der vorliegenden Erfindung ist es, eine verbesserte Präsentationseinrichtung mit einer Mehrzahl von Präsentationsmodulen, die elektrifiziert oder nicht elektrifiziert sind, bereitzustellen, sodass die Präsentationseinrichtung in einfacher Weise sowohl bei Umrüstungen als auch bei Neueinbauten in Verkaufslokalen variabel konfigurierbar sein soll

Diese Aufgabe wird durch eine Präsentationseinrichtung nach Anspruch 1 gelöst. Weitere vorteilhafte Ausführungsformen sind Gegenstand der rückbezogenen Unteransprüche.

Eine Präsentationseinrichtung gemäß der vorliegenden Erfindung dient der Präsentation von Waren und/oder von Text- und/oder Graphikinformation. Diese umfasst einen Montagerahmen mit einer Mehrzahl von Montageprofilen, die parallel und beabstandet zueinander angeordnet sind. Zweckmäßig sind die Montageprofile als Endlosprofile mit geeigneten Längen ausgebildet, die unter regemäßigen Abständen beabstandet und parallel zueinander angeordnet sind. Insbesondere können die Montageprofile sich kreuzend horizontal und senkrecht dazu verlaufend angeordnet sein, um eine Mehrzahl von Montagefeldern auszubilden, deren Größen zweckmäßig gleich sind, jedoch auch um ganzzahliges Vielfaches voneinander in einer oder zwei Dimensionen abweichen können, alternativ sind auch andere Abweichungen möglich. An den Montageprofilen ist eine Mehrzahl von rahmen- oder kastenförmigen Einsätzen lösbar befestigt, die jeweils der Präsentation von Waren und/oder von Text- und/oder Graphikinformation dienen. Die Einsätze weisen jeweils eine Mehrzahl von Seitenwänden auf, was insgesamt einen sehr stabilen und belastbaren rechteckförmigen Rahmen ermöglicht.

Erfindungsgemäß können die Einsätze als Module betrachtet werden, die individuell an dem Montagerahmen befestigt sind und jeweils unterschiedlich ausgelegt sein können. Dabei sind die Einsätze jeweils über deren Rückseiten lösbar an den Montageprofilen befestigt. Somit kann die Präsentationseinrichtung in einfacher Weise sowohl bei Umrüstungen als auch bei Neueinbauten in Verkaufslokalen variabel konfiguriert werden.

Zweckmäßig haben sämtliche Einsätze die gleichen Grundabmessungen, oder sind diese modular in Größen so unterteilt, dass diese einem Vielfachem oder einem ganzzahligen Bruchteil der Modulgröße entspricht, sodass die Module in einfacher Weise gelagert, beispielsweise gestapelt und transportiert werden können und ohne Weiteres gegeneinander ausgetauscht werden können, beispielsweise mit einer anderen Funktionalität.

Gemäß einer bevorzugten Ausführungsform sind die Einsätze unmittelbar über die Rückseiten der Seitenwände der Einsätze mit den Montageprofilen verbunden, wobei die Grundflächen der Module zweckmäßig den Grundflächen der Montagefelder des Montagerahmens oder einem ganzzahligen Vielfachen oder einem Bruchteil davon entsprechen. Somit ragen die Einsätze nicht, oder nur unwesentlich, über die von den Montageprofilen definierten Felder des Montagerahmens hinaus. Durch die Anordnung der Montageprofile kann somit in einfacher Weise die spätere Anordnung der Einsätze festgelegt werden, beispielsweise in einer Matrixanordnung in Reihen und Spalten, wobei die Einsätze selbst durch einfache Verbindungen in stets gleicher Weise an den Montageprofilen befestigt werden können, was insgesamt hilft, die zur Montage notwendige Zeit zu reduzieren.

Gemäß einer weiteren Ausführungsform sind auf zumindest einigen der Montageprofile Leiterbahnen angeordnet, insbesondere in Gestalt von Metallschienen und/oder Kunststoffschienen, die den Rückseiten der Einsätze zugewandt sind und von diesen her unmittelbar zugänglich sind. Dabei ist die lösbare Befestigung der Einsätze an den Montageprofilen zweckmäßig so ausgelegt, dass die Einsätze über die Leiterbahnen mit einer Versorgungsspannung, beispielsweise mit einer Niedervolt-Gleichspannung, versorgt werden, wenn die Einsätze lösbar an den Montageprofilen befestigt sind. Mit anderen Worten: bei der Befestigung der Einsätze an den Montageprofilen wird automatisch eine elektrische Versorgung der Einsätze über die Leiterbahnen bewerkstelligt, sodass aufwändige zusätzliche Schritte zur Elektrifizierung der Einsätze erfindungsgemäß entfallen können. Mit Hilfe der Versorgungsspannung können insbesondere Beleuchtungseinrichtungen, wie beispielsweise LED-Streifen oder Leuchtmittel, und/oder elektrische Geräte, wie beispielsweise Bildschirmanzeigen, Musik-Abspielgeräte und dergleichen, die in den Einsätzen vorgesehen sind, betrieben werden. Zu diesem Zweck können auch in den Einsätzen, beispielsweise in den Seitenwänden der Einsätze, elektrische Kabel oder Leiterbahnen sowie Anschlussmittel, wie beispielsweise Stecker oder Anschlusssockel, vorgesehen sein.

Im Falle einer Matrixanordnung der Montagefelder des Montagerahmens, wie vorstehend ausgeführt, kann es insbesondere ausreichend sein, wenn sich die Leiterbahnen nur entlang den horizontalen oder vertikalen Montageprofilen erstrecken, wobei es ausreichend sein kann, wenn die Leiterbahnen nur an der jeweiligen zweiten Leiterbahn der Gruppe von Leiterbahnen eines Typs (horizontal oder vertikal) vorgesehen sind.

Gemäß einer weiteren Ausführungsform sind auf den Rückseiten der Einsätze Kontaktstifte vorgesehen, die automatisch gegen die Leiterbahnen gedrückt werden, wenn die Einsätze lösbar an den Montageprofilen befestigt werden. Zu diesem Zweck können die Kontaktstifte in einem entspannten Normalzustand geringfügig über die Ebene hinausragen, die von der Rückseite oder dem Rahmen der Einsätze aufgespannt wird, und in einem Montagezustand mittels eines Rückstellelements, wie beispielsweise einer Feder oder eines Blechstreifens, gegen die zugeordneten Leiterbahnen gedrückt werden.

Gemäß einer weiteren Ausführungsform sind auf den Vorderseiten der Montageprofile jeweils Befestigungselemente vorgesehen, die zur Befestigung der hinteren Stirnseiten der Seitenwände der Einsätze an den Montageprofilen ausgelegt sind, sodass die Einsätze nicht, oder nur unwesentlich, über die von den Montageprofilen definierten Felder des Montagerahmens hinausragen. Dabei weisen die Befestigungselemente Längsnuten auf, die sich in Längsrichtung der jeweiligen Montageprofile erstrecken und in denen die Leiterbahnen angeordnet sind. Bevorzugt erfolgt die Verbindung der Einsätze mit den Montageprofilen durch einen Form- oder Kraftschluss innerhalb der Längsnuten oder in deren unmittelbarer Nähe, wobei gleichzeitig die elektrische Versorgung der Einsätze über die in den Längsnuten angeordneten Leiterbahnen gewährleistet ist. Auf diese Weise kann erfindungsgemäß eine sehr kompakte und platzsparende Montage einer Mehrzahl von variabel konfigurierbaren Präsentationsmodulen (Einsätzen) an einem Montagerahmen gewährleistet werden.

Gemäß einer bevorzugten weiteren Ausführungsform sind die hinteren Stirnseiten der Seitenwände jeweils formschlüssig mit den Befestigungselementen verbunden. Der Formschluss ist dabei ausgelegt, um ein ungewolltes Abziehen der Präsentationsmodule (Einsätze) senkrecht von dem Montagerahmen zu verhindern. Gleichzeitig können die Präsentationsmodule (Einsätze) zuverlässig in der von dem Montagerahmen festgelegten Ebene positioniert werden. Der Formschluss kann insbesondere mittels ersten Formschlusselementen, die auf den Rückseiten oder hinteren Stirnseiten der Seitenwände der Einsätze vorgesehen sind, und korrespondierend zu diesen ausgebildeten zweiten Formschlusselementen realisiert werden, die unmittelbar auf den Montageprofilen oder auf mit diesen verbundenen Befestigungselementen vorgesehen sind. Zweckmäßig sind die jeweiligen Formschlusselemente dabei einstückig mit dem jeweiligen Einsatz der zugeordneten Seitenwand bzw. mit dem Montageprofil oder dem damit verbundenen Befestigungselement ausgebildet, was sich insbesondere durch Kunststoff-Spritzgussverfahren in einfacher Weise realisieren lässt.

Gemäß einer weiteren Ausführungsform sind auf den hinteren Stirnseiten der Seitenwände jeweils Rasthaken vorgesehen, die in die Längsnuten der Befestigungselemente eingesteckt und gegen Schrägen oder Ausnehmungen der Längsnuten elastisch vorgespannt sind, wenn die Einsätze lösbar an den Montageprofilen befestigt sind. Alternativ können auf den hinteren Stirnseiten der Seitenwände jeweils Rastausnehmungen vorgesehen sein, die in die Rasthaken eingreifen, die in den Längsnuten vorgesehen sind und die elastisch gegen die Rastausnehmungen vorgespannt sind, wenn die Einsätze lösbar an den Montageprofilen befestigt sind.

Gemäß einer weiteren Ausführungsform sind die Befestigungselemente jeweils längsverschieblich an den Montageprofilen gesichert gehalten. Beispielsweise können die Befestigungselemente hierzu als Reiter oder Klammern ausgebildet sein, die die Montageprofile jeweils zumindest teilweise umgreifen und die in Längsrichtung der Montageprofile verstellt werden und in der geeigneten Position mittels Verbindungsmitteln, wie beispielsweise Schrauben oder Clips, an den Montageprofilen befestigt werden können. Auf diese Weise kann die Grundkonfiguration des Montagerahmens und der von den Montageprofilen definierten Felder in einfacher Weise variabel vorgegeben werden. Die Befestigungselemente können dabei gleichzeitig auch als Halter zum Halten der vorgenannten Leiterbahnen an den Montageprofilen dienen.

Gemäß einer weiteren Ausführungsform sind die Montageprofile jeweils als rechteckige oder quadratische Endlos-Hohlprofile mit einem Hohlraum ausgebildet und sind die Montageprofile mittels Steckverbindern, die jeweils in die Hohlräume von zwei miteinander verbundenen Montageprofilen eingesteckt sind, mit dem Montagerahmen verbunden. Vorteilhaft ist, dass die Geometrie des Montagerahmens durch einfaches Verbinden von wenigen Montageprofilen mit Standardlängen, in einfacher Weise sehr variabel vorgegeben werden kann. Der Montagerahmen kann dabei insbesondere bei der Montage vor Ort aufgebaut werden, was Lagerungs- und Transportaufwand weiter reduziert. Mittels 90°-Steckverbindern oder T-Steckverbindern lässt sich so insbesondere eine Matrixanordnung der Felder des Montagerahmens mit einer Mehrzahl von parallel zueinander verlaufenden horizontalen Montageprofilen und einer Mehrzahl von sich senkrecht zu diesen erstreckenden und parallel zueinander verlaufenden vertikalen Montageprofilen realisieren. Wenn der Steckverbinder andere Winkel vorgibt, lässt sich damit jedoch auch eine beliebige andere Geometrie realisieren, insbesondere einen beliebigen Neigungswinkel von Teilabschnitten der Präsentationseinrichtung, beispielsweise einer Rückwand oder eines unteren Abschnittes derselben.

Gemäß einer weiteren Ausführungsform weisen zumindest einige der Einsätze Rückwände auf, so dass diese ein Herausfallen von zu präsentierenden Waren verhindern können und die Einsätze somit zur Aufbewahrung und/oder Halterung von zu präsentierenden Waren ausgelegt sind. Zweckmäßig können in die Seitenwände oder dort vorgesehene Haltevorsprünge Einlegeböden je nach Bedarf eingesteckt werden.
Gemäß einer weiteren Ausführungsform umfasst die jeweilige Rückwand eine lichtleitende Platte, die auch unmittelbar von der jeweiligen Rückwand ausgebildet sein kann, wobei in die lichtleitende Platte für eine Hintergrundbeleuchtung Licht eines LED-Streifen eingekoppelt ist. Mittels der Hintergrundbeleuchtung können die in dem Präsentationsmodul (Einsatz) aufgenommenen oder gehaltenen Waren noch werbewirksamer präsentiert werden. Oder die Hintergrundbeleuchtung dient zur werbewirksamen Ausleuchtung einer Text- und/oder Graphikinformation. Hierzu können insbesondere die Vorderseiten von zumindest einigen der Einsätze mittels einer transparenten oder opaken Abdeckung abgedeckt sein, insbesondere aus einem transparenten oder opaken, plattenförmigen Kunststoff, wobei die Abdeckung ausgelegtist, um eine Text- und/oder Graphikinformation darzubieten.
In einer weiteren Ausführungsform ist der Montagerahmen auf einem rampenförmigen Korpus angeordnet, so dass der Montagerahmen schräg liegend befestig ist. Dies erlaubt es, dass die Produkte die weiter hinten stehen für den Betrachter angehoben werden, damit er diese besser wahrnimmt. Erfindungsgemäß ist der Montagrahmen leiterförmig mit horizontalen und vertikalen Montageprofilen ausgebildet, wobei in den Leiterfeldern die kastenförmigen Einsätze angeordnet sind.
Hierbei sind vorzugsweise das horizontale und vertikale Montageprofil klemmend miteinander verbunden, wobei das horizontale Montageprofil vorzugsweise aus Kunststoff gefertigt ist und sich bereichsweise klemmend um das vertikale Montageprofil erstreckt.
Eine Präsentationseinrichtung, wie hierin offenbart, kann an einem Montagerahmen in einem Präsentationsmöbel aufgenommen oder an einem Wandpaneel befestigt sein.

### Figurenübersicht

Nachfolgend wird die Erfindung in beispielhafter Weise und unter Bezugnahme auf die beigefügten Zeichnungen beschrieben werden, woraus sich weitere Merkmale, Vorteile und zu lösenden Aufgaben ergeben werden. Es zeigen:
- Fig. 1: eine Präsentationseinrichtung für Waren gemäß der vorliegenden Erfindung;
- Fig. 2: einen Montagerahmen der Präsentationseinrichtung gemäß der Fig. 1, der in ein Präsentationsmöbel eingebaut ist;
- Fig. 3: den Montagerahmen der Präsentationseinrichtung gemäß der Fig. 2 in einer perspektivischen Seitenteilansicht, wobei eine Mehrzahl von kastenförmigen Einsätzen an dem Montagerahmen befestigt ist;
- Fig. 4a: in einer schematischen Schnittansicht ein Montageprofil gemäß einer Ausführungsform;
- Fig. 4b: in einer schematischen Schnittansicht ein Montageprofil gemäß einer weiteren Ausführungsform;
- Fig. 4c: in einer schematischen Schnittansicht ein Montageprofil gemäß einer weiteren Ausführungsform;
- Fig. 4d: in einer schematischen Schnittansicht das Zusammenstecken der Montagepröfile zu einem Montagerahmen;
- Fig. 5a: in einer perspektivischen Teilansicht die Befestigung eines kastenförmigen Einsatzes mit Hintergrundbeleuchtung an einem Feld eines Montagerahmens einer Präsentationseinrichtung für Waren gemäß der vorliegenden Erfindung;
- Fig. 5b: ein weiteres Beispiel für einen kastenförmigen Einsatz;
- Fug, 6: in einer perspektivischen Teilansicht den Prozess der Befestigung eines kastenförmigen Einsatzes an einem Montageprofil gemäß der vorliegenden Erfindung;
- Fig. 7: eine Teilansicht einer Präsentationseinrichtung für Waren gemäß einer weiteren Ausführungsform;
- Fig. 8: einen Teil des Montagerahmens der Präsentationseinrichtung gemäß der Fig. 7;

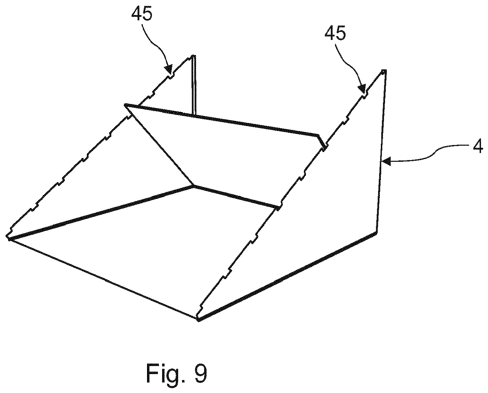

- Fig. 9: eine Rampe, auf die ein Montagerahmen angeordnet werden kann, in einem Zwischenzustand bevor die Rampe vollständig aufgeklappt ist;
- Fig. 10: die Rampe nach Fig. 9 auf der ein Montagerahmen angeordnet ist, der in einer Teilexplosionsform dargestellt ist;
- Fig. 11: einen kastenförmigen Einsatz, der lochförmige Aufnahmen für Lippenstifte aufweist, in denen die Lippenstifte angeordnet sind;
- Fig. 12: eine Schnittansicht durch den vorderen Bereich des kastenförmigen Einsatzes, mit einem drehbar gelagerten Deckel, der in unterschiedlichen Winkeln angestellt werden kann;
- Fig. 13: eine Explosionsansicht eines kastenförmigen Einsatzes;
- Fig. 14: eine Seitenansicht des kastenförmigen Einsatzes mit den Kontakten;
- Fig. 15: einen Montagerahmen, mit zwei vertikalen Montageprofilen als Träger und einer Reihe von horizontalen Montageprofilen als Sprossen;
- Fig. 16: eine Explosionsansicht der Fig. 15 mit einer Detailansicht eines Kopfbereiches eines horizontalen Montageprofils, das aufgeklipst wird;
- Fig. 17: eine Seitenansicht des Montageprofils aus der Fig. 15 mit einer Reihe von kastenförmigen Einsätzen, die entsprechende Produkte aufgenommen haben.

In den Figuren bezeichnen identische Bezugszeichen identische Elemente oder Gruppen von Elementen.

### Ausführliche Beschreibung von bevorzugten Ausführungsformen

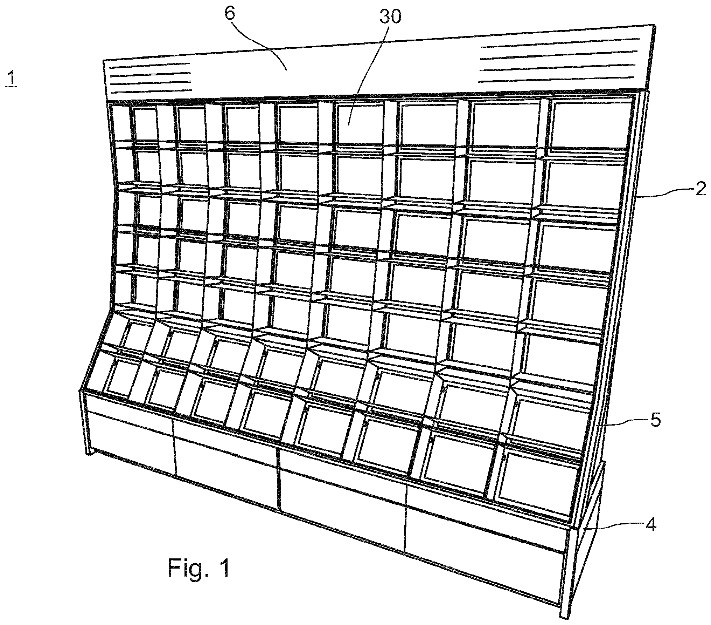

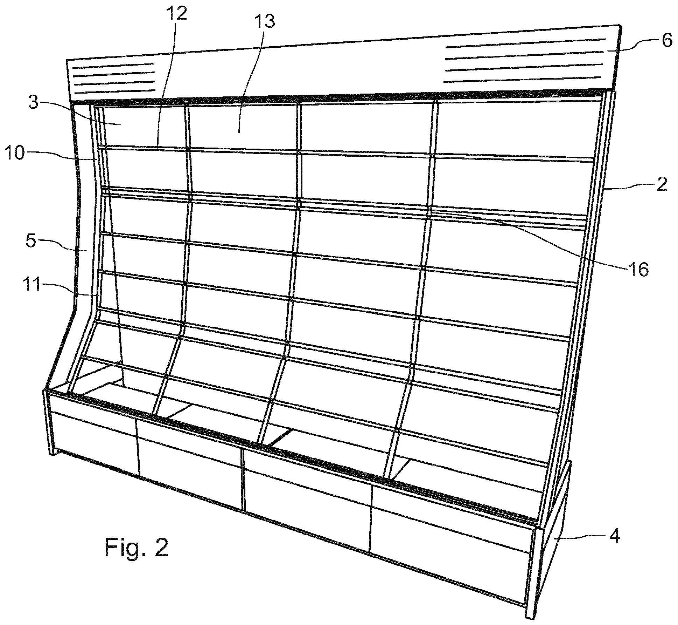

Die Fig. 1 zeigt eine Präsentationseinrichtung 1 für Waren gemäß der vorliegenden Erfindung. Diese umfasst eine Mehrzahl von kastenförmig Einsätzen 30 mit rechteckiger Grundfläche, die in einer Matrixanordnung angeordnet sind und in den in der Fig. 2 dargestellten Montagerahmen eingesteckt sind, der in einem Präsentationsmöbel 2 aufgenommen ist, das einen sich horizontal erstreckenden Korpus 4 mit mehreren Schubladen, vertikalen Seitenwänden 5 und eine obere Werbefläche 6 zur Darbietung von Text- und/oder Graphikinformation aufweist.

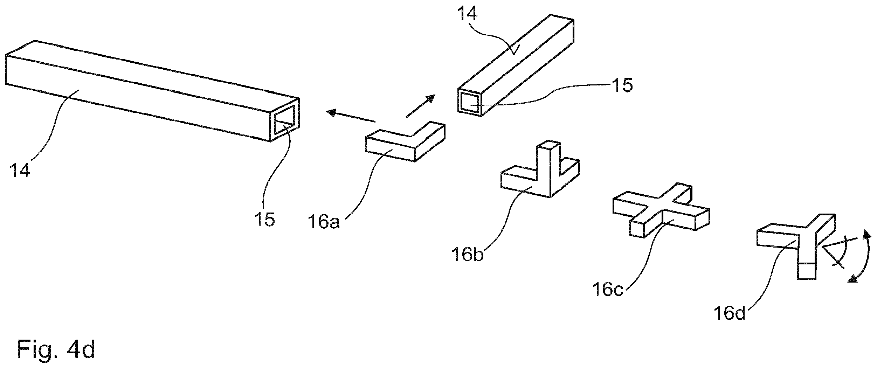

Die Fig. 2 zeigt die Anordnung des Montagerahmens 10 innerhalb des Präsentationsmöbels 2. Der Montagerahmen 10 ist von einer Mehrzahl von horizontalen Montageprofilen 12 und sich senkrecht dazu erstreckenden Montageprofilen 13 ausgebildet, die mittels Steckverbindern 16 miteinander verbunden sind, wie nachfolgend anhand der Fig. 4d näher erläutert. Der Montagerahmen 10 ist durch die Montageprofile 11, 12 in eine Mehrzahl von Feldern 13 gleicher Größe unterteilt, deren Höhe/Breite im Wesentlichen einem ganzzahligen Vielfachen der Höhe/Breite der Einsätze 30 entspricht, die an dem Montagerahmen 10 befestigt werden sollen. Selbstverständlich können die Montageprofile 11, 12 auch abschnittsweise unterschiedliche Unterteilungen des Montagerahmens 10 festlegen.

Gemäß der Fig. 2 erstreckt sich nur der obere Abschnitt des Montagerahmens 10 parallel zu der Rückwand 3 des Präsentationsmöbels 2. Der mittlere und untere Abschnitt des Montagerahmens 10 erstrecken sich jeweils unter einem spitzen Winkel zu der Ebene des oberen Abschnitts des Montagerahmens 10. Der jeweilige Winkel kann in einfacher Weise mittels der Steckverbinder 16 eingestellt werden, über die die Montageprofile 11, 12 jeweils miteinander verbunden sind, wie nachfolgend anhand der Fig. 4d näher erläutert.

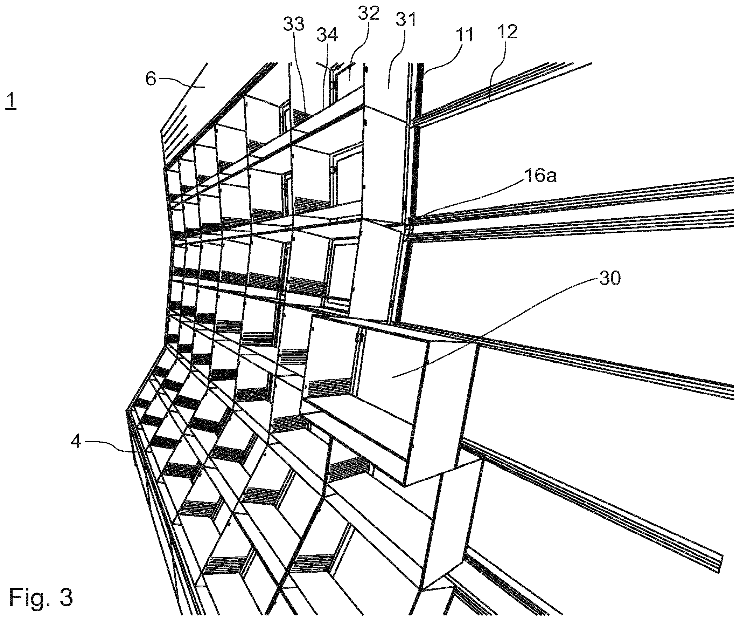

Die Fig. 3 zeigt den Montagerahmen der Präsentationseinrichtung gemäß der Fig. 2 in einer perspektivischen Seitenteilansicht. Dabei sind noch nicht sämtliche Einsätze 30 an dem Montagerahmen befestigt. Der mit dem Bezugszeichen 30 bezeichnete Einsatz wird gerade an den Montagerahmen angenähert, um an diesem befestigt zu werden. Gemäß der Fig. 3 sind die Einsätze 30 kastenförmig ausgebildet, mit einer Rückwand 32 und vier Seitenwänden 31. Auf den Innenseiten der vertikalen Seitenwände 31 sind in einer Rasteranordnung mehrere Haltevorsprünge 33 vorgesehen, in die zumindest ein Einlegeboden 34 zur Abstützung von zu präsentierenden Waren eingesteckt werden kann.

Weitere Einsätze können auch rahmenförmig ausgebildet sein, also ohne Rückwand, was den freien Durchblick etwa auf die dahinter befindliche Rückwand 3 des Präsentationsmöbels 2 (vgl. Fig. 2), eine Wand oder eine Werbeanzeige, ermöglicht.

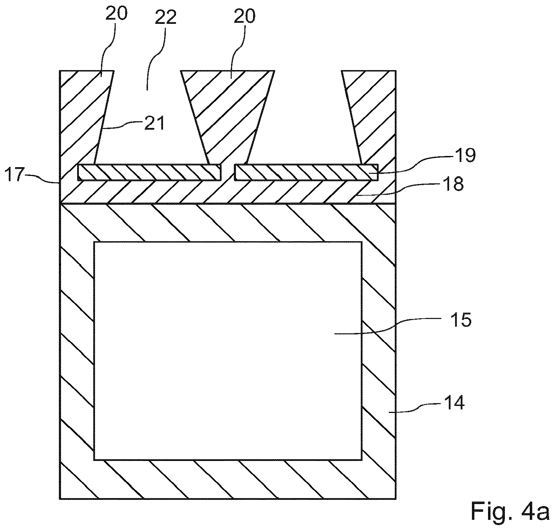

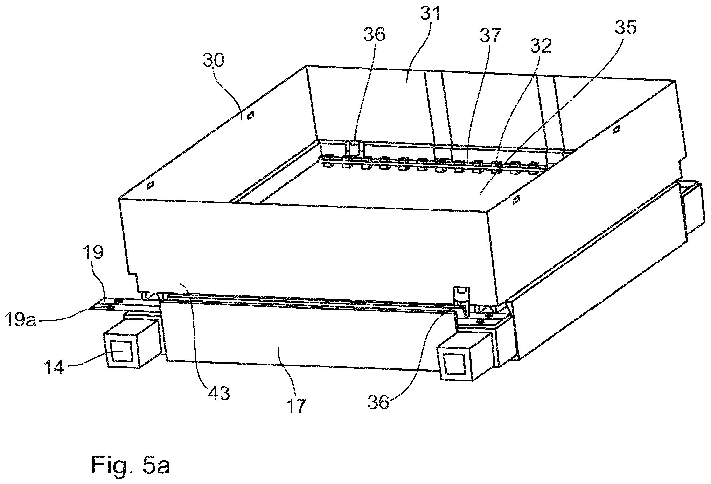

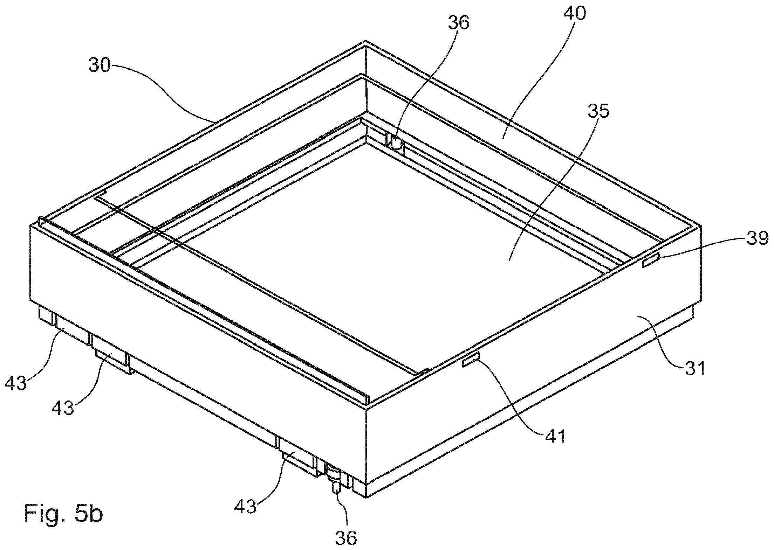

Die Fig. 4a zeigt weitere Einzelheiten des verwendeten Montageprofils 14, das gemäß diesem Ausführungsbeispiel einen quadratischen Querschnitt aufweist und zumindest in den Endbereichen und bevorzugt über dessen gesamte Länge einen Hohlraum 15 aufweist. Ein solches Montageprofil 14 kann mit geeigneter Länge von extrudierten oder stranggezogenen Endlosprofilen aus Kunststoff und/oder Metall abgetrennt werden. Auf der Vorderseite des Montageprofils 14, die dem zugeordneten Einsatz (nicht gezeigt) zugewandt ist, ist ein Leiterbahnhalter 17 vorgesehen, der als Befestigungselement zum Befestigen eines Einsatzes 30 an dem Montageprofil 14 dient und entweder an dem Montageprofil 14 befestigt ist oder einstückig mit diesem ausgebildet ist. Gemäß der Fig. 4a sind in den Längsnuten 22 des Leiterbahnhalters 17 zwei elektrisch leitende Leiterbahnen 19 zueinander isoliert angeordnet. Über die Längsnuten 22 sind die Leiterbahnen 19 für Kontaktstifte 36 (vgl. Fig. 5a und Fig. 5b) des zugeordneten Einsatzes 30 unmittelbar zugänglich.

In der Anordnung gemäß der Fig. 3 können sich die Leiterbahnen über die gesamte Breite und/oder Höhe des Montagerahmens 10 erstrecken, oder über die Breite und/oder Höhe eines Unterabschnitts davon, der mit einer elektrischen Spannung versorgt werden soll.

Erfmdungsgemäß ist die lösbare Befestigung der Einsätze 30 an den Montageprofilen 14 so ausgelegt, dass die Einsätze 30 über die Leiterbahnen 19 automatisch mit einer Versorgungsspannung versorgt werden, wenn die Einsätze 30 lösbar an den Montageprofilen 14 befestigt sind. Zur Befestigung der Einsätze 30 an den Montageprofilen 14 können grundsätzlich beliebige Verbindungstechniken eingesetzt werden, insbesondere Verschraubungen, Klettverbindungen, lösbare Klebeverbindungen oder beliebige geeignete formschlüssige oder kraftschlüssige Verbindungstechniken.

Besonders zweckmäßig sind auf der Vorderseite des Montageprofils 14, die dem Einsatz (nicht gezeigt) zugewandt ist, Formschlussgebilde vorgesehen. Diese können entweder unmittelbar auf der Vorderseite des Montageprofils 14 ausgebildet sein oder unmittelbar in dem Leiterbahnhalter 17, wie in der Fig. 4a gezeigt. Genauer gesagt sind die Längsnuten 22 des Leiterbahnhalters 17 gemäß der Fig. 4a invers V-förmig ausgebildet und weisen schräg aufwärts geneigte Schrägen 21 auf, die nach oben hin aufeinander zulaufen. In diese Längsnuten 22 greifen korrespondierend ausgebildete Rasthaken ein, die auf der Rückseite des zugeordneten Einsatzes, insbesondere auf den hinteren Stirnseiten der Seitenwände desselben, ausgebildet sind.

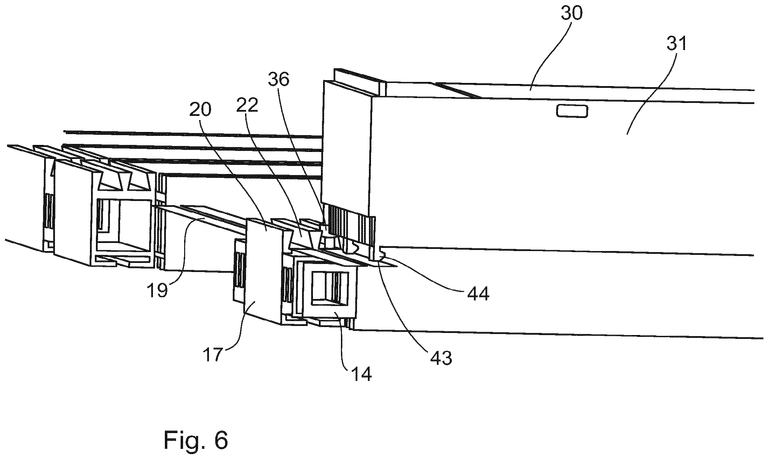

Ein Beispiel für einen solchen Rasthaken 43 ist in der Fig. 6 gezeigt. Gemäß der Fig. 6 sind die Rasthaken 43 einstückig mit der Seitenwand 31 des jeweiligen Einsatzes 30 ausgebildet und ragen in deren Verlängerung von der Rückseite des Einsatzes 30 ab. Die Rasthaken 43 weisen jeweils eine Schräge 44 auf, die beim Einstecken des Rasthakens 43 in eine Längsnut 22 des Montageprofils 14 vollfächig oder abschnittsweise an der Schräge 21 der Längsnut 22 anliegt, um den Einsatz 30 an dem zugeordneten Montageprofil gegen ein Abziehen senkrecht zum Montageprofil zu sichern.

Genauer gesagt gelangt beim Einstecken des Rasthakens 43 in eine Längsnut 22 des Montageprofils 14 zunächst das vordere Ende der Schräge 44 des Rasthakens in Anlage mit dem vorderen Ende des Vorsprungs 20 des Leiterbahnhalters 17. Beim weiteren Einführen des Rasthakens 43 in die Längsnut 22 gleitet die Schräge 44 des Rasthakens 43 entlang dem vorderen Ende des Vorsprungs 20, bis schließlich die Schräge 44 des Rasthakens 43 vollflächig oder abschnittsweise an der Schräge 21 der Längsnut 22 anliegt. Um das Abziehen des Rasthakens 43 aus der Längsnut 22 zu erleichtern, ist auch die Oberseite des Rasthakens 43 abgeschrägt ausgebildet.

Aus der Fig. 6 ist ersichtlich, dass der Leiterbahnhalter 17 sich nicht über die gesamte Länge des Montageprofils 14 zu erstrecken braucht, sondern dass es ausreichend sein kann, wenn dieser nur abschnittsweise, in Zuordnung zu dem jeweiligen Raster des Montagerahmens, an diesem angeordnet ist. Für eine noch größere Variabilität kann es dabei von Vorteil sein, wenn der Leiterbahnhalter 17 entlang dem jeweiligen Montageprofil 14 verschoben werden kann und schließlich an einer geeigneten Position, in Zuordnung zu dem jeweiligen Raster des zu bildenden Montagerahmens, befestigt werden kann, beispielsweise mittels geeigneter Schraub-, Steck- oder Clipsverbindungen.

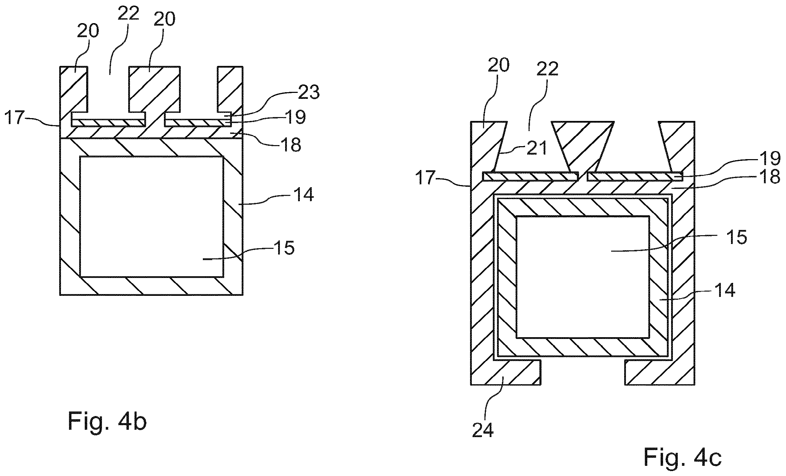

Die Fig. 4b zeigt eine Variante eines Montageprofils. Gemäß der Fig. 4b sind die Längsnuten 22 nicht keilförmig sondern invers T-förmig ausgebildet, mit rechteckförmigen Aussparungen 23 oberhalb der Leiterbahnen 19, in die korrespondierend dazu ausgebildete Rasthaken der Einsätze eingreifen können.

Die Fig. 4c zeigt eine weitere Variante eines Montageprofils, nach der der Leiterbahnhalter 17 das Montageprofil 14 mittels Vorsprüngen 24 am gegenüberliegenden Ende klammerartig umgreift. Der Reibschluss zwischen dem Leiterbahnhalter 17 und dem Montageprofil 14 kann ausreichend für eine zuverlässige Positionierung des Einsatzes an dem Montageprofil 14 bemessen sein und bei Überschreiten einer Mindestkraft gleichzeitig die vorstehend beschriebene Verschiebbarkeit des Leiterbahnhalters 17 entlang dem Montageprofil 14 gewährleisten.

Die Fig. 4d zeigt, wie als Hohlprofile ausgebildete Montageprofile 14 mittels Steckverbindern 16a-16d, die jeweils in die Hohlräume 15 von zwei miteinander verbundenen Montageprofilen 14 eingesteckt werden, zu einem Montagerahmen mit variabler Geometrie zusammengesteckt werden können. Die Geometrie des Montagerahmens kann insbesondere durch den Winkel der jeweils verwendeten Steckverbinder 16a-16d in einfacher aber zuverlässiger Weise vorgegeben werden.

Die Fig. 5a zeigt in einer perspektivischen Teilansicht die Befestigung eines kastenförmigen Einsatzes 30 mit Hintergrundbeleuchtung an einem Feld eines Montagerahmens, wie vorstehend beschrieben. Wenn die Rasthaken 43 des Einsatzes 30 in die Längsnuten 22 der Leiterbahnhalter 17 eingesteckt sind (vgl. Fig. 6), drücken die elektrischen Kontaktstifte 36 des Einsatzes 30 gegen die jeweiligen Leiterbahnen 19, wodurch eine elektrische Versorgung einer Hintergrundbeleuchtung bewerkstelligt wird, die durch Einkoppeln des Lichts eines LED-Streifens 37 mit einer Mehrzahl von LEDs 38 in die Stirnseite der lichtleitenden Platte 35 realisiert ist. Die lichtleitende Platte 35 kann zugleich die Rückwand des Einsatzes 30 ausbilden. Mittels der Hintergrundbeleuchtung können Artikel, die auf der Seitenwand 31 des Einsatzes oder auf Einlegeböden oder dergleichen angeordnet sind, werbewirksam beleuchtet werden oder eine Text- und/oder Graphikinformation hinterleuchtet werden. Hierzu kann die Vorderseite des Einsatzes 30 auch mittels einer transparenten oder opaken Abdeckung 40 abgedeckt sein, auf der die darzubietende Text- und/oder Graphikinformation in der bekannten Weise vorgesehen ist, wie in der Fig. 5b gezeigt. Diese Text- und/oder Graphikinformation kann auch in eine Aufnahme 42 der Abdeckung 40 eingesteckt sein. Gemäß der Fig. 5b ist die Abdeckung 40 durch Einstecken von an dieser ausgebildeten Vorsprüngen 41 in Aussparungen 39 in der Seitenwand 31 des Einsatzes 30 an dem Einsatz 30 befestigt.

Die vorgenannten elektrische Versorgung des Einsatzes kann auch zur elektrischen Versorgung beliebiger anderer Leuchtmittel oder Beleuchtungseinrichtungen oder von elektrischen Geräten, die in dem Einsatz aufgenommen oder an diesem befestigt sind, dienen, beispielsweise von Bildschirmanzeigen oder Musik-Abspielgeräten.

Wie in der Fig. 5a gezeigt, sind in den Leiterbahnen 19 Bohrungen 19a vorgesehen. Bei der Befestigung des Einsatzes 30 an den Montageprofilen 14 können die Kontaktstifte 36 auch formschlüssig in diese Bohrungen 19a eingreifen, um den elektrischen Kontakt herzustellen. Hierzu können die Bohrungen 19a insbesondere in der gewünschten Rasterung der Einsätze 30 auf den Leiterbahnen 19 ausgebildet sein. Die Bohrungen 19a können auch zur Verbindung von zwei Leiterbahnen 19 dienen, beispielsweise durch Verschrauben.

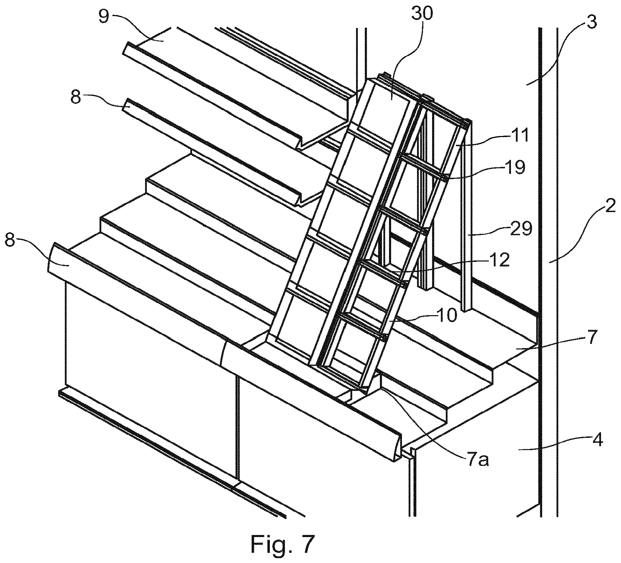

Die Fig. 7 zeigt eine Teilansicht einer Präsentationseinrichtung für Waren gemäß einer weiteren Ausführungsform. Gemäß der Fig. 7 ist auf einem Korpus 4 mit mehreren Schubladen eines Verkaufsstands 2 ein gestuft ausgebildetes Auflageprofil 7 mit mehreren Ebenen und einem senkrecht davon abragenden vorderen Rand 8 angeordnet. An der Rückwand 3 des Verkaufsstands 2 können weitere Regalböden 9 in üblicher Weise befestigt sein.

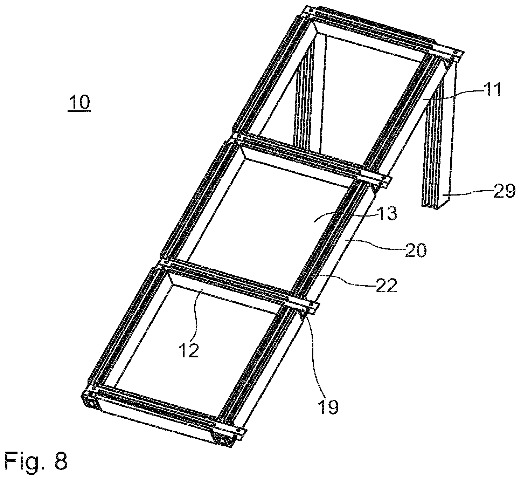

In der untersten Ebene des Auflageprofils 7 ist eine Einlegeschiene 7a aufgenommen, auf der das untere Ende eines Montagerahmens 10 abgestützt ist. In diesen ist eine Mehrzahl von Einsätzen 30 in der vorstehend beschriebenen Weise eingehängt oder eingesteckt. Die Einsätze 30 werden über die Leiterbahnen 19 in der vorstehend beschriebenen Weise mit einer elektrischen Spannung versorgt. Das obere Ende des Montagerahmens 10 ist mit einer Stützstrebe 29 verbunden, über die der Montagerahmen 10 weiterhin auf der obersten Ebene des Auflageprofils 7 und an der Rückseite 3 des Verkaufsstands 2 abgestützt ist. Die Fig. 8 zeigt einen Ausschnitt dieses leiterförmig ausgebildeten Montagerahmens 10 in vergrößerter Darstellung.

Statt den Montagerahmen 10 mittels der Stützstrebe 29 auf der obersten Ebene des Auflageprofils 7 und an der Rückseite 3 des Verkaufsstands 2 abzustützen, können auf den Rückseiten der vertikalen Montageprofile 11 auch Haken vorgesehen sein, über die der Montagerahmen unmittelbar in die vorderen Ränder 8 der Regalböden 9 eingehängt werden kann. Auf diese Weise kann ein bestehender Verkaufsstand 2 rasch und variabel umgerüstet werden, nämlich durch abschnittsweises oder vollständiges Abdecken durch ein Präsentationssystem, das aus einer Mehrzahl von Einsätzen 30 besteht, die durch Einhängen oder Befestigung an einem Montagerahmen 10 in einer regelmäßigen Anordnung angeordnet sind und über den Montagerahmen 10 automatisch mit einer Versorgungsspannung versorgt werden können.

Wie dem Fachmann beim Studium der vorstehenden Beschreibung ohne weiteres ersichtlich sein wird, kann das Präsentationssystem kostengünstig und formschön bereitgestellt werden und sehr variabel an individuelle Kundenwünsche angepasst werden. Durch die Elektrifizierung der Präsentationsmodule (Einsätze) können Waren oder Text- und/oder Graphikinformation sehr werbewirksam präsentiert werden. Das vorgestellte Präsentationssystem eignet sich insbesondere zur Präsentation von Kosmetikartikeln mit Ausführung der Präsentationsmodule (Einsätze) aus Kunststoff und Verwendung von Beleuchtungseffekten, insbesondere Hintergrundbeleuchtung, in zumindest einigen der Präsentationsmodule (Einsätze). Das Präsentationssystem gemäß der vorliegenden Erfindung kann in entsprechender Weise jedoch auch zur Präsentation beliebiger anderer Produkte eingesetzt werden, beispielsweise von Konsum- oder Elektronikartikeln.

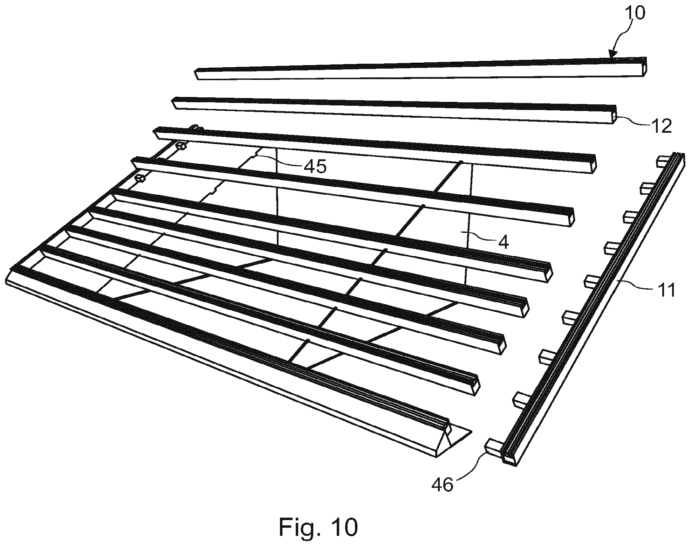

In einer weiteren Ausführungsform ist der Korpus 4, als zusammenklappbare Rampe ausgebildet. Auf dieser Rampe kann dann eine Leiterstruktur 10 befestigt werden, wie man sie in Fig. 10 sieht. Dabei ist die Rampe in einem Bereich von 20-80°ausgebildet, vorzugsweise 30-60°. Der Korpus 4 kann natürlich auch fest und nicht zusammenklappbar ausgebildet sein, was jedoch beim Transport zu einem höheren Volumen führt. An der Oberkante der Schrägen weist der Korpus 4 Ausnahmen 45 auf, in die die horizontal verlaufenden Montageprofile der Leiterstruktur bzw. des Montagerahmens 10 eingerastet bzw. eingeklinkt werden. Hierdurch wird vermieden, dass der Montagerahmen auf der rampenförmigen Schräge abrutscht. Der Fig. 10 ist der Montagerahmen 10 zu entnehmen, der auf den Korpus 4 aufgelegt ist, wobei der Montagerahmen vertikale Montageprofile 11 und horizontale Montageprofile 12 aufweist, wobei diese miteinander durch Zapfen 46 verbunden sind, die sich in das Profil erstrecken. Dadurch dass der Montagerahmen auf dem rautenförmigen Korpus 4 angeordnet ist, entsteht eine Präsentationsfläche die nach hinten ansteigt.

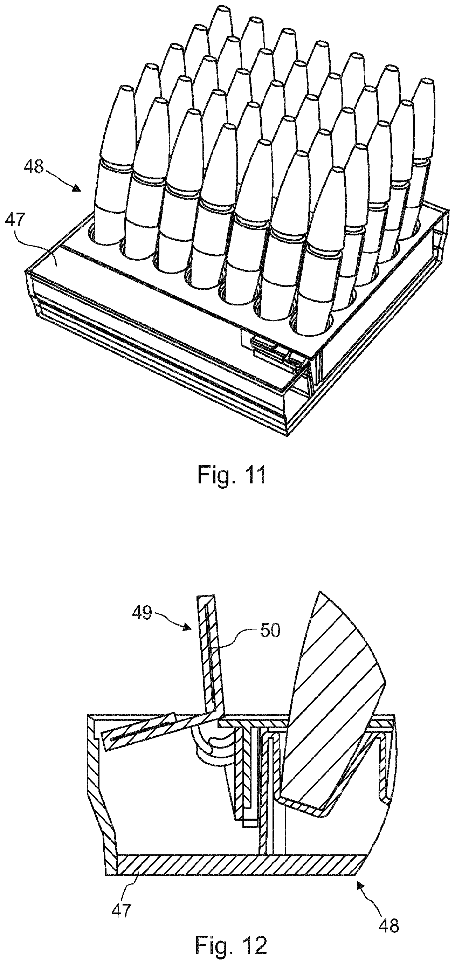

Die Fig. 11 zeigt einen kastenförmigen Einsatz, der lochförmige Aufnahmen für Lippenstifte aufweist, in denen die Lippenstifte angeordnet sind. Ein solcher kastenförmiger Einsatz, kann auf einem Montagerahmen angeordnet werden, der eine Leiterstruktur aufweist, wie zum Beispiel in Fig. 10 dargestellt. Eine Vielzahl von solchen kastenförmigen Einsätzen können dann, auch in unterschiedlichen Größen, auf einer solchen Leiterstruktur angeordnet werden. Wie der Fig. 11 zu entnehmen ist, weist der kastenförmige Einsatz einen vorderen Bereich 47 auf, in dem produktbeschreibende Informationen hinterlegt werden können, und der speziell beleuchtet ist, und einen hinteren Bereich 48, in dem das Produkt selber angeordnet ist, das vorne beschrieben wurde.
Die Fig. 12 zeigt den vorderen Bereich 47 im Detail, der einen drehbaren Deckel 49 aufweist, der je nach Neigung des kastenförmigen Einsatzes angestellt werden kann, um somit dem Betrachter einem optimalen Blickwinkel zu ermöglichen. Der drehbare Deckel 49, weist einen Aufnahmeschlitz 50 auf, in den ein Stück Papier einlegt werden kann, dass das Produkt beschreibt.

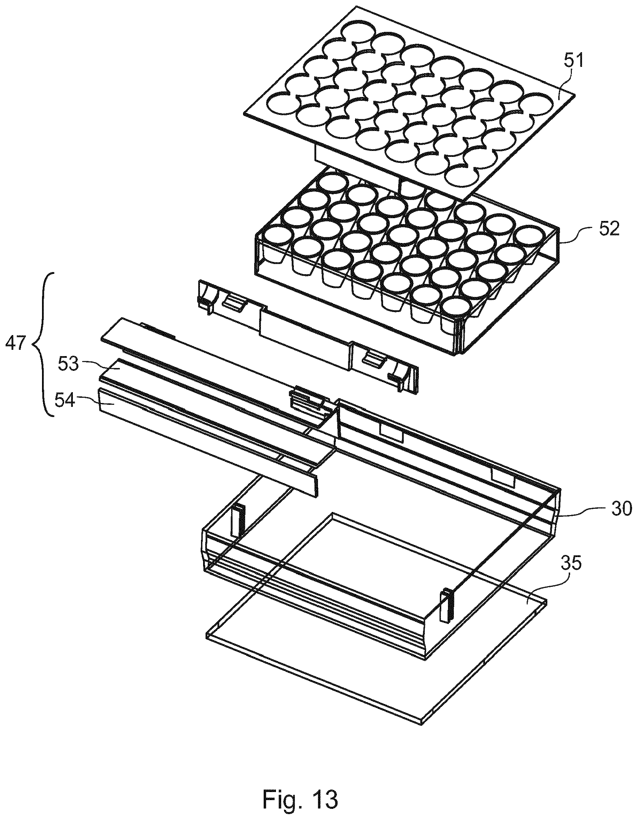

Die Fig. 13 zeigt eine Explosionsansicht des kastenförmigen Einsatzes, mit einer Deckplatte 51, mit einem Haltebereich, 52, in dem die Produkte eingesetzt werden können. Einem Vorderbereich 47, der aus dem drehbaren Deckel und entsprechenden Halterungen ausgebildet ist wobei entsprechende Linsen/transparente Scheiben 53 und 54 ausgebildet sind, um das Licht der LEDs, die im Bodenbereich angeordnet sind, entsprechend in den vorderen Bereich zu leiten. Weiterhin ist ein Einsatz 30 mit entsprechenden Seitenwänden und einer Bodenplatte oder einer lichtleitenden Platte 35 vorgesehen.

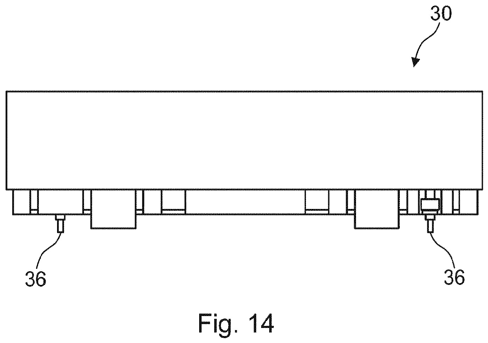

Fig. 14 zeigt in einer Seitenansicht die Kontakte, die in der Regel diagonal in gegenüberliegenden Ecken des kastenförmigen Einsatzes angeordnet sind, und die mit den Montageprofilen in Kontakt treten. In der Regel sind die stiftförmigen Kontakte mit Federn ausgestattet, so dass diese auf die Montageprofile drücken und einen Kontakt herstellen.

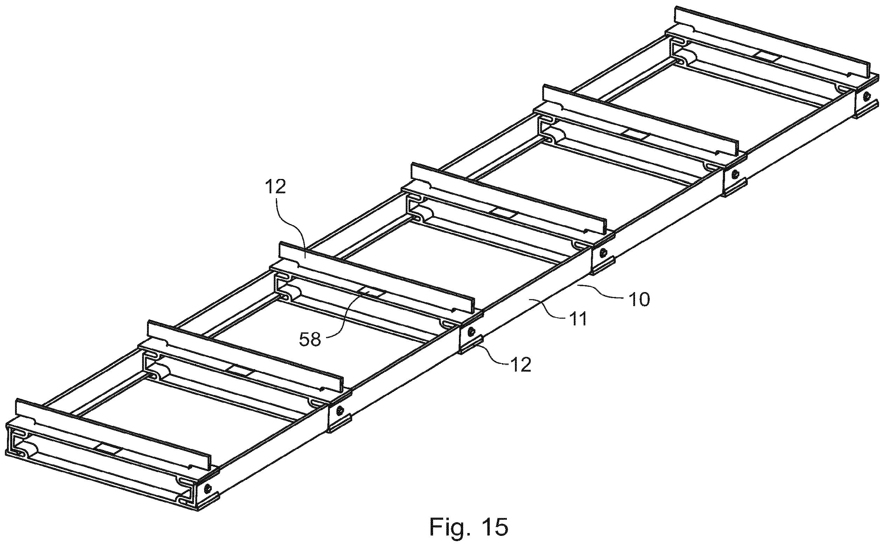

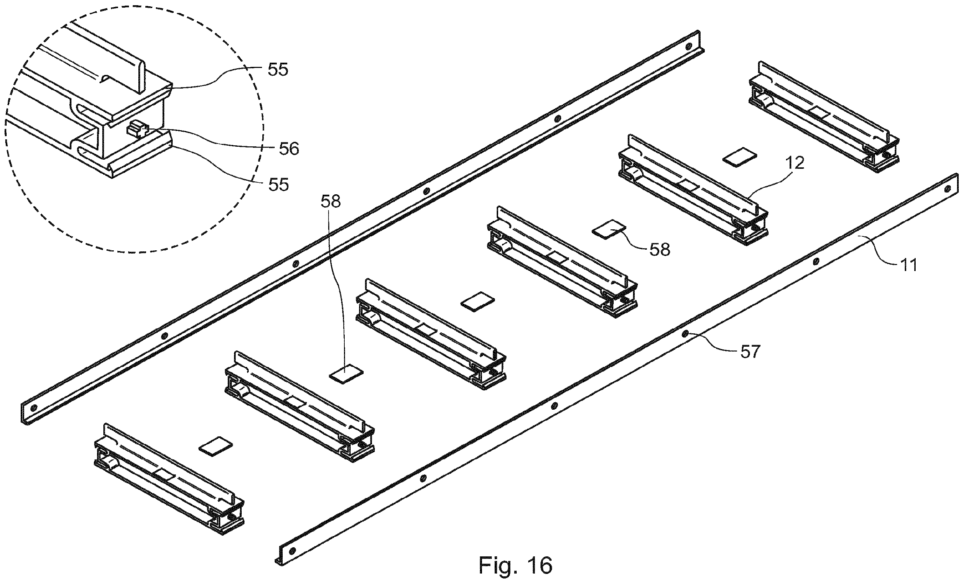

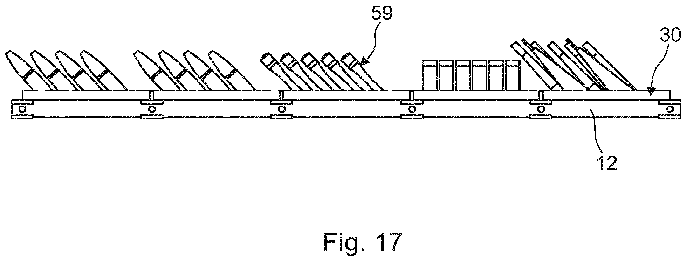

Die Fig. 15 zeigt einen leiterförmigen Montagerahmen 10 mit vertikalen Montageprofilen 11 und horizontalen Montageprofilen 12. Die horizontalen Montageprofile sind vorzugsweise aus Kunststoff gefertigt und weisen wie Fig. 16 zeigt Klemmbereiche 55 auf, die sich um das vertikale Montageprofil klemmen und diese somit arretieren. Hierzu greifen zwei Klemmelemente von oben und unten um das vertikale Profil und lassen es hinter entsprechenden Nasen einrasten. Zusätzlich ist noch ein Zapfen 56 vorgesehen, der sich in eine Bohrung 57 erstreckt, so dass auch ein Verrutschen des horizontalen Montageprofils auf dem vertikalen Montageprofil verhindert werden kann. Diese Bohrungen können in festen Rastern ausgebildet sein. Fernerweisen die horizontalen Montageprofile noch Magnete 58 auf, die eine Verbindung mit den kastenförmigen Einsätzen eingehen, damit diese nicht so leicht aus dem Montagerahmen entfernt werden können, sondern stabil und fest darin gelagert sind. Die Fig. 17 zeigt eine Seitenansicht des Montagerahmens 10 aus den Fig. 15 und 16 an, wobei in diesen Montagerahmen eine Vielzahl von kastenförmigen Einsätzen eingebracht sind, die wiederum Produkte aufnehmen.
Eine Stromführung kann in vertikalen Montageprofilen ausgebildet sein, da diese durch vertikale Montageprofile aus Kunststoff verbunden sind, können unterschiedliche Polaritäten gegeben sein. Die kastenförmigen Einsätze können Stifte aufweisen, die jeweils in Kontakt mit den aus Metall gefertigten vertikalen Profilen treten, um Spannung aufzunehmen, damit die LEDs, die in den kastenförmigen Einätzen angeordnet sind, mit Spannung versorgt werden.

### Bezugszeichenliste

- 1: Warenpräsentationssystem
- 2: Präsentationsmöbel
- 3: Rückwand
- 4: Korpus
- 5: Seitenwand
- 6: obere Werbefläche
- 7: gestuftes Auflageprofil
- 7a: Einlegeschiene
- 8: vorderer Rand
- 9: Regalboden
- 10: Montagerahmen
- 11: vertikales Montageprofil
- 12: horizontales Montageprofil
- 13: Feld
- 14: Montageprofil
- 15: Hohlraum
- 16a: Steckverbinder
- 16b: Steckverbinder
- 16c: Kreuz-Steckverbinder
- 16d: Winkel-Steckverbinder
- 17: Leiterbahnhalter
- 18: Basis
- 19: Leiterbahn
- 19a: Bohrung
- 20: Vorsprung
- 21: Schräge
- 22: Längsnut
- 23: Aussparung
- 24: Vorsprung
- 29: Stützstrebe
- 30: Einsatz
- 31: Seitenwand
- 32: Rückwand
- 33: Haltevorsprung
- 34: Einlegeboden
- 35: lichtleitende Platte
- 36: elektrischer Kontaktstift
- 37: LED-Streifen
- 38: LED
- 39: Aussparung
- 40: vordere Abdeckung
- 41: Vorsprung
- 42: Aufnahme
- 43: Rasthaken
- 44: Schräge
- 45: Ausnahmen/Aussparungen
- 46: Zapfen
- 47: vorderer Bereich
- 48: hinterer Bereich
- 49: drehbarer Deckel
- 50: Aufnahmeschlitz
- 51: Deckplatte
- 52: Haltebereich
- 53, 54: Linsen
- 55: Klemmbereich
- 56: Zapfen
- 57: Bohrung
- 58: Magnet

## Patentansprüche

1. Präsentationseinrichtung, insbesondere für Waren, umfassend
einen Montagerahmen (10) mit einer Mehrzahl von Montageprofilen (12, 11; 14), die parallel und beabstandet zueinander angeordnet sind, und
einer Mehrzahl von rahmen- oder kastenförmigen Einsätzen (30), die an den Montageprofilen lösbar befestigt sind, wobei
die Einsätze (30) jeweils eine Mehrzahl von Seitenwänden (31) aufweisen, die einen rechteckförmigen Rahmen ausbilden, und
die Einsätze jeweils über deren Rückseiten lösbar an den Montageprofilen befestigt sind,
**dadurch gekennzeichnet, dass** der Montagrahmen leiterförmig mit horizontalen und vertikalen Montageprofilen (11, 12) ausgebildet ist, wobei in den Leiterfeldern (13) die kastenförmigen Einsätze (30) angeordnet sind.

2. Präsentationseinrichtung nach Anspruch 1, wobei auf zumindest einigen der Montageprofile (12,11; 14) Leiterbahnen (19) angeordnet sind und wobei die lösbare Befestigung der Einsätze (30) an den Montageprofilen so ausgelegt ist, dass die Einsätze über die Leiterbahnen (19) mit einer Versorgungsspannung, insbesondere mit einer Niedervolt-Gleichspannung, versorgt sind, wenn die Einsätze (30) lösbar an den Montageprofilen befestigt sind, um Beleuchtungseinrichtungen und/oder elektrische Geräte der Einsätze mit der Versorgungsspannung zu versorgen,

3. Präsentationseinrichtung nach Anspruch 2, wobei auf den Rückseiten der Einsätze (30) Kontaktstifte (36) vorgesehen sind, die gegen die Leiterbahnen (19) gedrückt sind, wenn die Einsätze (30) lösbar an den Montageprofilen (12, 11; 14) befestigt sind.

4. Präsentationseinrichtung nach einem der Ansprüche 2 oder 3, wobei auf den Vorderseiten der Montageprofile (30) jeweils Befestigungselemente (17) vorgesehen sind, die zur Befestigung der hinteren Stirnseiten der Seitenwände (31) der Einsätze (30) an den Montageprofilen (30) ausgelegt sind, wobei die Befestigungselemente (17) Längsnuten (22) aufweisen, die sich in Längsrichtung der jeweiligen Montageprofile erstrecken und in denen die Leiterbahnen (19) angeordnet sind.

5. Präsentationseinrichtung nach Anspruch 4, wobei die hinteren Stirnseiten der Seitenwände (31) jeweils formschlüssig mit den Befestigungselementen (17) verbunden sind.

6. Präsentationseinrichtung nach Anspruch 5, wobei
auf den hinteren Stirnseiten der Seitenwände (31) jeweils Rasthaken (43) vorgesehen sind, die in die Längsnuten (22) der Befestigungselemente (17) eingesteckt und gegen Schrägen (21) oder Ausnehmungen (23) der Längsnuten (22) elastisch vorgespannt sind, oder
auf den hinteren Stirnseiten der Seitenwände (31) jeweils Rastausnehmungen vorgesehen sind, in die Rasthaken eingreifen, die in den Längsnuten (22) vorgesehen sind und die elastisch gegen die Rastausnehmungen vorgespannt sind,
wenn die Einsätze (30) lösbar an den Montageprofilen (30) befestigt sind.

7. Präsentationseinrichtung nach Anspruch 6, wobei die Rasthaken (43) einstückig mit den Seitenwänden (31) der Einsätze (30) oder mit Seitenwänden der Längsnuten (22) ausgebildet sind.

8. Präsentationseinrichtung nach einem der Ansprüche 4 bis 7, wobei die Befestigungselemente (17) längsverschieblich an den Montageprofilen (12, 11; 14) gesichert gehalten sind.

9. Präsentationseinrichtung nach einem der vorhergehenden Ansprüche, wobei die Montageprofile (12, 11; 14) jeweils als rechteckige oder quadratische Endlos-Hohlprofile mit einem Hohlraum (15) ausgebildet sind und wobei die Montageprofile (12, 11; 14) mittels Steckverbindern (16a-16d), die jeweils in die Hohlräume von zwei miteinander verbundenen Montageprofilen eingesteckt sind, zu dem Montagerahmen (10) verbunden sind, wobei der Montagerahmen eine Mehrzahl von parallel zueinander verlaufenden horizontalen Montageprofilen und eine Mehrzahl von sich senkrecht zu diesen erstreckenden und parallel zueinander verlaufenden vertikalen Montageprofilen aufweist.

10. Präsentationseinrichtung nach einem der vorhergehenden Ansprüche, wobei zumindest einige der Einsätze (30) Rückwände (32) aufweisen und zur Aufbewahrung und/oder Halterung von zu präsentierenden Waren ausgelegt sind.

11. Präsentationseinrichtung nach Anspruch 10, wobei die jeweilige Rückwand eine lichtleitende Platte (35) umfasst oder von dieser ausgebildet ist, in die für eine Hintergrundbeleuchtung Licht eines LED-Streifen (37) eingekoppelt ist.

12. Präsentationseinrichtung nach einem der vorhergehenden Ansprüche, wobei die Vorderseiten von zumindest einigen der Einsätze (30) mittels einer transparenten oder opaken Abdeckung (40) abgedeckt sind, wobei die Abdeckung ausgelegt ist, um eine Text- und/oder Graphikinformation darzubieten.

13. Präsentationseinrichtung nach einem der vorhergehenden Ansprüche, wobei der Montagerahmen (10) in einem Präsentationsmöbel (2) aufgenommen oder an einem Wandpaneel befestigt ist oder auf einem rampenförmigen Korpus (4), auf dem der Montagerahmen schräg liegend angeordnet ist, befestigt ist.

14. Präsentationseinrichtung nach einem der vorhergehenden Ansprüche , wobei das horizontale und vertikale Montageprofil (11,12) klemmend miteinander verbunden sind, wobei das horizontale Montageprofil vorzugsweise aus Kunststoff gefertigt ist und sich bereichsweise klemmend um das vertikale Montageprofil erstreckt.

## Claims

1. Presentation device, in particular for goods, comprising a mounting frame (10) having a plurality of mounting profiles (12, 11; 14) arranged parallel and spaced from each other; and a plurality of frame or box-shaped inserts (30) releasably attached to the mounting profiles; wherein the inserts (30) each having a plurality of side walls (31) forming a rectangular frame, and the inserts are detachably attached to the mounting profiles via their rear sides, **characterized in that** the mounting frame is formed in the form of a ladder with horizontal and vertical mounting profiles (11, 12), the box-shaped inserts (30) being arranged in the ladder fields (13).

2. Presentation device according to claim 1, wherein conductor tracks (19) are arranged on at least some of the mounting profiles (12, 11; 14) and wherein the detachable fastening of the inserts (30) to the mounting profiles is designed such that the inserts are supplied with a supply voltage, in particular with a low-voltage direct voltage, via the conductor tracks (19) when the inserts (30) are detachably fastened to the mounting profiles in order to supply lighting devices and/or electrical devices of the inserts with the supply voltage.

3. Presentation device according to claim 2, wherein contact pins (36) are provided on the rear sides of the inserts (30) which are pressed against the tracks (19) when the inserts (30) are detachably attached to the mounting profiles (12, 11; 14).

4. Presentation device according to one of claims 2 or 3, wherein fastening elements (17) being provided on the front sides of the mounting profiles (30), which are designed for fastening the rear end faces of the side walls (31) of the inserts (30) to the mounting profiles (30), the fastening elements (17) having longitudinal grooves (22) which extend in the longitudinal direction of the respective mounting profiles and in which the conductor tracks (19) are arranged.

5. Presentation device according to claim 4, wherein the rear end faces of the side walls (31) each being positively fitted connected to the fastening elements (17).

6. Presentation device according to claim 5, wherein the rear end faces of the side walls (31) are each provided with locking hooks (43) which are inserted into the longitudinal grooves (22) of the fastening elements (17) and are elastically prestressed against slopes (21) or recesses (23) of the longitudinal grooves (22), or
the rear end faces of the side walls (31) are provided with detent recesses, engage in the detent hooks provided in the longitudinal grooves (22) and which are elastically prestressed against the detent recesses,
when the inserts (30) are detachably attached to the mounting profiles (30).

7. Presentation device according to claim 6, wherein the locking hooks (43) are integrally formed with the side walls (31) of the inserts (30) or with side walls of the longitudinal grooves (22).

8. Presentation device according to one of claims 4 to 7, wherein the fastening elements (17) being secured to the mounting profiles (12, 11; 14) in a longitudinally displaceable manner.

9. Presentation device according to one of the preceding claims, wherein the mounting profiles (12, 11; 14) are each formed as rectangular or square continuous hollow profiles with a cavity (15) and wherein the mounting profiles (12, 11; 14) are connected to the mounting frame (10) by means of plug-in connectors (16a-16d), which are respectively inserted into the cavities of two interconnected mounting profiles, wherein the mounting frame has a plurality of horizontal mounting profiles extending parallel to one another and a plurality of vertical mounting profiles extending perpendicular to these and extending parallel to one another.

10. Presentation device according to one of the preceding claims, at least some of the inserts (30) having back walls (32) and being designed for storing and/or holding goods to be presented.

11. Presentation device according to claim 10, wherein the respective back wall comprises or is formed from a light-guiding plate (35) into which light of an LED strip (37) is coupled for background illumination.

12. Presentation device according to one of the preceding claims, wherein the faces of at least some of the inserts (30) being covered by a transparent or opaque cover (40), the cover being adapted to provide text and/or graphic information.

13. Presentation device according to one of the preceding claims, wherein the mounting frame (10) is received in a presentation furniture (2) or fixed to a wall panel or is fixed to a ramp-shaped body (4) on which the mounting frame is arranged obliquely.

14. Presentation device according to one of the preceding claims, wherein the horizontal and vertical mounting profiles (11, 12) are clamped together, wherein the horizontal mounting profile is preferably made of plastic and extends in areas clamped around the vertical mounting profile.

## Revendications

1. Un dispositif de présentation, en particulier pour des marchandises, comprenant un cadre de montage (10) avec une pluralité de profilés de montage (12, 11; 14) qui sont disposés parallèlement et espacés l'un de l'autre; et une pluralité d'inserts en forme de cadre ou de boîte (30) fixés de manière amovible aux profilés de montage; dans lequel les inserts (30) ont chacun une pluralité de parois latérales (31) formant un cadre rectangulaire, et les inserts sont fixés de manière amovible aux profilés de montage par l'intermédiaire de leurs côtés arrière, **caractérisé en ce que** le cadre de montage est réalisé sous la forme d'une échelle ayant des profilés de montage horizontaux et verticaux (11, 12), les inserts en forme de boîte (30) étant disposés dans les espacements d'échelle (13).

2. Le dispositif de présentation selon la revendication 1, dans lequel des pistes conductrices (19) sont disposées sur au moins certains des profilés de montage (12, 11; 14) et dans lequel la fixation amovible aux profilés de montage des inserts (30) est conçue de telle façon à alimenter les inserts avec une tension d'alimentation, en particulier avec une tension continue à faible voltage, via les pistes conductrices (19) lorsque les inserts (30) sont fixés de manière amovible aux profilés de montage afin d'alimenter au moyen de la tension d'alimentation des dispositifs lumineux et/ou des dispositifs électriques des inserts.

3. Le dispositif de présentation selon la revendication 2, dans lequel des broches de contact (36) sont disposées sur les côtés arrières des inserts (30), qui viennent s'appuyer sur les pistes (19) lorsque les inserts (30) sont fixés de manière amovible aux profilés de montage (12, 11 ; 14).

4. Le dispositif de présentation selon l'une des revendications 2 ou 3, dans lequel des éléments de fixation (17) sont prévus sur les côtés avant des profilés de montage (30), lesquels sont conçus pour fixer aux profilés de montage (30) des surfaces d'extrémité arrière des parois latérales (31) des inserts (30), les éléments de fixation (17) ayant des rainures longitudinales (22) qui s'étendent suivant la direction longitudinale des profilés de montage respective et dans lesquelles les pistes conductrices (19) sont disposées.

5. Le dispositif de présentation selon la revendication 4, dans lequel les surfaces d'extrémité arrière des parois latérales (31) sont chacune raccordés d'une manière serrée aux éléments de fixation (17).

6. Le dispositif de présentation selon la revendication 5, dans lequel les surfaces d'extrémité arrière des parois latérales (31) sont chacune dotées de crochets de verrouillage (43) qui sont insérés dans les rainures longitudinales (22) des éléments de fixation (17) et sont précontraintes élastiquement contre des chanfreins (21) ou des évidements (23) des rainures longitudinales (22), ou
les surfaces d'extrémité arrière des parois latérales (31) sont fournies avec des évidements de verrouillage, qui sont en prise avec les crochets de verrouillage fournis dans les rainures longitudinales (22) et qui sont élastiquement précontraints contre les évidements de verrouillage,
lorsque les inserts (30) sont fixés de manière amovible aux profilés de montage (30).

7. Le dispositif d'affichage selon la revendication 6, dans lequel les crochets de verrouillage (43) sont de fabrication avec les parois latérales (31) des inserts (30) ou avec les parois latérales des rainures longitudinales (22).

8. Le dispositif de présentation selon l'une des revendications 4 à 7, dans lequel les éléments de fixation (17) sont maintenus solidaires des profilés de montage (12, 11, 14) d'une manière amovible longitudinale.

9. Le dispositif de présentation selon l'une des revendications précédentes, dans lequel les profilés de montage (12, 11, 14) présentent chacun la forme de profilés continus creux, de section rectangulaire ou carrée, avec une cavité (15) et dans lequel les profilés de montage (12, 11, 14) sont fixés au cadre de montage (10) par le biais de connecteurs de branchement (16a-16d), qui sont respectivement insérés dans les cavités de deux profilés de montage interconnectés, dans lequel le cadre de montage a une pluralité de profilés de montage horizontaux parallèles les uns aux autres et, s'étendant perpendiculairement, une pluralité de profilés de montage verticaux parallèles les uns aux autres.

10. Le dispositif de présentation selon l'une des revendications précédentes, dans lequel au moins certains des inserts (30) présentent des parois arrière (32) et sont conçus pour le stockage et / ou le maintien de marchandises devant être présentées.

11. Le dispositif de présentation selon la revendication 10, dans lequel la paroi arrière respective comporte ou est formée d'une plaque photoconductrice (35) dans laquelle une lumière d'une bande de DEL (37) est couplée pour un rétro-éclairage.

12. Le dispositif de présentation selon l'une quelconque des revendications précédentes, dans lequel les faces d'au moins certains des inserts (30) sont recouvertes d'un couvercle transparent ou opaque (40), le couvercle étant adapté pour présenter des informations textuelles et / ou graphiques.

13. Le dispositif de présentation selon l'une des revendications précédentes, dans lequel le cadre de montage (10) est logé dans un meuble de présentation (2) ou est fixé à un panneau mural ou sur un corps en forme de rampe (4) sur lequel le cadre de montage est disposé obliquement.

14. Le dispositif de présentation selon l'une des revendications précédentes, dans lequel les profilés de montage horizontaux et verticaux (11, 12) sont reliés entre eux par serrage, dans lequel le profilé de montage horizontal est de préférence réalisé en plastique et s'étendant sur certaines zones autour du profilé de montage vertical.
